# EUROPEAN PATENT SPECIFICATION

(11) **EP 3 244 236 B1**
(45) Date of publication and mention of the grant of the patent: **19.02.2020**
(21) Application number: 15876966.1
(22) Date of filing: 24.11.2015
(51) Int. Cl.: G01T 1/20, G21K 4/00, H01L 27/146

(54) **RADIATION DETECTOR AND MANUFACTURING METHOD THEREFOR**
STRAHLENDETEKTOR UND HERSTELLUNGSVERFAHREN DAFÜR
DÉTECTEUR DE RAYONNEMENT ET SON PROCÉDÉ DE FABRICATION

(30) Priority: 09.01.2015 JP 2015003405
(43) Date of publication of application: 15.11.2017
(73) Proprietor: Canon Electron Tubes & Devices Co., Ltd., Otawara-shi, Tochigi (JP)
(72) Inventor: HOMMA Katsuhisa, Otawara-shi, Tochigi 324-8550 (JP); TAKATORI Koji, Otawara-shi, Tochigi 324-8550 (JP)
(74) Representative: Henkel & Partner mbB
(86) International application number: PCT/JP2015/082893
(87) International publication number: WO 2016/111093

(56) References cited:
- WO-A1-2006/136532
- WO-A1-2012/105185
- JP-A- 2007 298 464
- JP-A- 2014 122 820
- US-A1- 2012 288 688

## Description

### [Technical Field]

Embodiments of the invention relates to a radiation detector and a method for manufacturing same.

### [Background Art]

In a radiation detector, a substrate that is formed from a transparent material such as glass, etc., multiple photoelectric converters that are provided in a matrix configuration on the substrate, a scintillator layer that covers the multiple photoelectric converters and converts radiation into visible light, i.e., fluorescence, a moisture-resistant body that covers the scintillator layer, etc., are provided.

Also, to increase the utilization efficiency of the fluorescence and improve the sensitivity characteristics, there are also cases where a reflective layer is further provided on the scintillator layer.

The scintillator layer is provided to cover the region (the effective pixel region) where the multiple photoelectric converters are provided.

Here, in the case where the scintillator layer is formed using vacuum vapor deposition, a tilted portion is formed in the peripheral edge portion of the scintillator layer. The thickness of the tilted portion gradually decreases toward the outer side of the scintillator layer. Therefore, the thickness of the tilted portion is thin compared to the portion at the central region of the scintillator layer. In the case where the thickness of the scintillator layer is thin, there is a risk that the image quality in the region of the tilted portion may decrease because the light emission luminance decreases.

In such a case, the decrease of the image quality can be suppressed by providing the tilted portion at a position distal to the effective pixel region on the outer side. However, downsizing of the radiation detector cannot be realized in the case where the tilted portion is provided at the position distal to the effective pixel region on the outer side.

Therefore, it is desirable to develop a radiation detector and a method for manufacturing the radiation detector in which degradation of the image quality can be suppressed even when there is a tilted portion above the effective pixel region, and downsizing of the radiation detector can be realized.

### [Citation List]

### [Patent Literature]

[Patent Literature 1] JP 2009-128023 A

### [Summary of Invention]

### [Technical Problem]

A problem to be solved by the invention is to provide a radiation detector and a method for manufacturing the radiation detector in which degradation of the image quality can be suppressed even when there is a tilted portion above the effective pixel region, and downsizing of the radiation detector can be realized.

### [Technical Solution]

A radiation detector according to an embodiment includes an array substrate, a scintillator layer, a wall body, and a filled portion, where the array substrate includes a substrate and multiple photoelectric conversion elements, the multiple photoelectric conversion elements are provided on one surface side of the substrate, the scintillator layer includes a first fluorescent material and is provided on the multiple photoelectric conversion elements, the wall body surrounds the scintillator layer and is provided on the one surface side of the substrate, and the filled portion includes a second fluorescent material and is provided between the scintillator layer and the wall body.

The scintillator layer includes a tilted portion in a peripheral edge portion of the scintillator layer; and a thickness of the tilted portion gradually decreases toward the outer side of the scintillator layer.

The filled portion is provided on the tilted portion.

### [Brief Description of Drawings]

[FIG. 1]

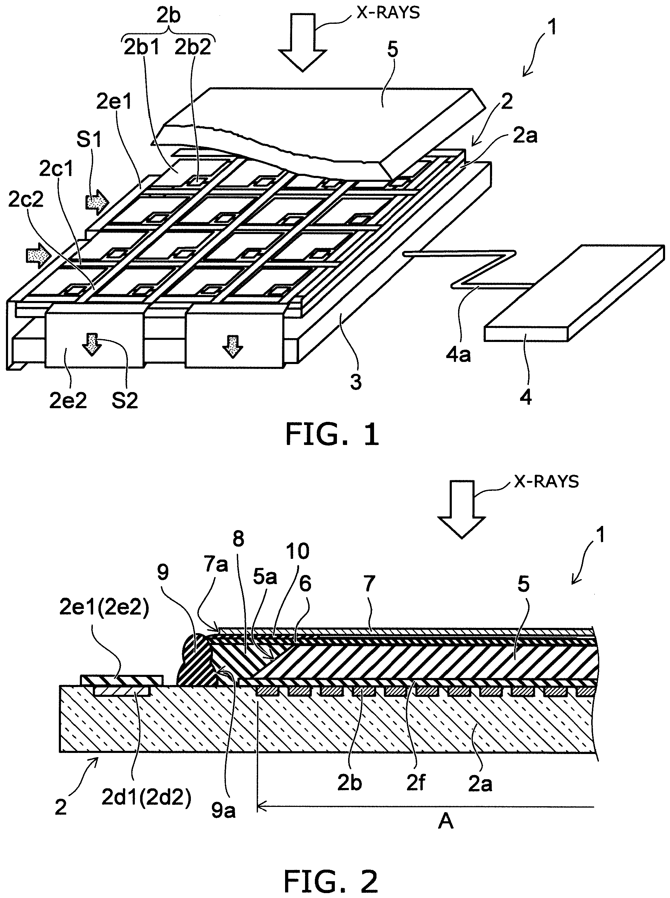

   FIG. 1 is a schematic perspective view for illustrating the X-ray detector 1 according to the first embodiment.
[FIG. 2]
   FIG. 2 is a schematic cross-sectional view of the X-ray detector 1.
[FIG. 3]

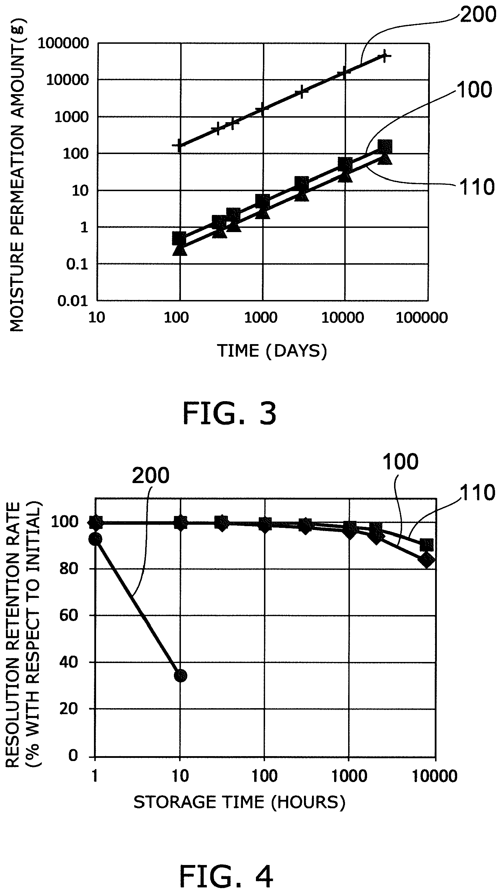

   FIG. 3 is a graph for illustrating the change of the moisture permeation amount under a high-temperature high-humidity environment (60 °C-90% RH).
[FIG. 4]
   FIG. 4 is a graph for illustrating the change of resolution characteristics under a high-temperature high-humidity environment (60 °C-90% RH).

### [Description of Embodiments]

Embodiments will now be illustrated with reference to the drawings. Similar components in the drawings are marked with the same reference numerals; and a detailed description is omitted as appropriate.

Also, other than X-rays, the radiation detectors according to the embodiments of the invention also are applicable to various radiation such as γ-rays, etc. Here, as an example, a case relating to X-rays is described as a typical example of radiation. Accordingly, applications to other radiation also are possible by replacing "X-ray" of the embodiments recited below with "other radiation."

### [First embodiment]

First, an X-ray detector 1 according to a first embodiment will be illustrated.

FIG. 1 is a schematic perspective view for illustrating the X-ray detector 1 according to the first embodiment.

To avoid complexity in FIG. 1, a reflective layer 6, a moisture-resistant body 7, a filled portion 8, a wall body 9, an adhesive layer 10, a protective layer 2f, etc., are not illustrated.

FIG. 2 is a schematic cross-sectional view of the X-ray detector 1.

To avoid complexity in FIG. 2, control lines (or gate lines) 2c1, data lines (or signal lines) 2c2, a signal processor 3, an image transmitter 4, etc., are not illustrated.

The X-ray detector 1, which is a radiation detector, is an X-ray planar sensor that detects X-ray images which are radiation images. For example, the X-ray detector 1 can be used in general medical applications, etc. However, the applications of the X-ray detector 1 are not limited to general medical applications.

As shown in FIG. 1 and FIG. 2, an array substrate 2, the signal processor 3, the image transmitter 4, a scintillator layer 5, the reflective layer 6, the moisture-resistant body 7, the filled portion 8, the wall body 9, and the adhesive layer 10 are provided in the X-ray detector 1.

The array substrate 2 includes a substrate 2a, photoelectric converters 2b, the control lines 2c1, the data lines 2c2, and the protective layer 2f.

The substrate 2a has a sheet configuration and is formed from a transparent material such as alkali-free glass, etc.

The photoelectric converters 2b are multiply provided on one surface of the substrate 2a.

The photoelectric converters 2b have rectangular configurations and are provided in regions that are defined by the control lines 2c1 and the data lines 2c2. The multiple photoelectric converters 2b are arranged in a matrix configuration.

One photoelectric converter 2b corresponds to one pixel (pixel).

A thin film transistor (TFT; Thin Film Transistor) 2b2 which is a switching element and a photoelectric conversion element 2b1 are provided in each of the multiple photoelectric converters 2b.

Also, a not-illustrated storage capacitor that stores the signal charge converted by the photoelectric conversion element 2b1 can be provided. For example, the not-illustrated storage capacitor has a rectangular flat sheet configuration and can be provided under each of the thin film transistors 2b2. However, the photoelectric conversion element 2b1 also can be used as the not-illustrated storage capacitor according to the capacitance of the photoelectric conversion element 2b1.

For example, the photoelectric conversion element 2b1 can be a photodiode, etc.

The thin film transistor 2b2 performs the switching of the storing and the discharging of the charge generated by the fluorescence being incident on the photoelectric conversion element 2b1. The thin film transistor 2b2 can include a semiconductor material such as amorphous silicon (a-Si), polysilicon (P-Si), etc. The thin film transistor 2b2 includes a gate electrode, a source electrode, and a drain electrode. The gate electrode of the thin film transistor 2b2 is electrically connected to the corresponding control line 2c1. The source electrode of the thin film transistor 2b2 is electrically connected to the corresponding data line 2c2. The drain electrode of the thin film transistor 2b2 is electrically connected to the corresponding photoelectric conversion element 2b1 and a not-illustrated storage capacitor.

The control lines 2c1 are multiply provided to be parallel to each other at a prescribed spacing. For example, the control lines 2c1 extend in the row direction.

The multiple control lines 2c1 are electrically connected respectively to multiple interconnect pads 2d1 provided at the peripheral edge vicinity of the substrate 2a. An end of each of multiple interconnects provided in a flexible printed circuit board 2e1 is electrically connected respectively to the multiple interconnect pads 2d1. The other end of each of the multiple interconnects provided in the flexible printed circuit board 2e1 is electrically connected to a not-illustrated control circuit provided in the signal processor 3.

The data lines 2c2 are multiply provided to be parallel to each other at a prescribed spacing. The data lines 2c2 extend in a direction (e.g., the column direction) orthogonal to the direction in which the control lines 2c1 extend.

The multiple data lines 2c2 are electrically connected respectively to multiple interconnect pads 2d2 provided at the peripheral edge vicinity of the substrate 2a. An end of each of multiple interconnects provided in a flexible printed circuit board 2e2 is electrically connected respectively to the multiple interconnect pads 2d2. The other end of each of the multiple interconnects provided in the flexible printed circuit board 2e2 is electrically connected to a not-illustrated amplifier/converter circuit provided in the signal processor 3.

The protective layer 2f is provided to cover the photoelectric converters 2b, the control lines 2c1, and the data lines 2c2.

The protective layer 2f can be formed from an insulating material such as silicon nitride (SiN), an acrylic resin, etc.

The signal processor 3 is provided on the side opposite to the side where the photoelectric converters 2b of the substrate 2a are provided.

A not-illustrated control circuit and a not-illustrated amplifier/converter circuit are provided in the signal processor 3.

The not-illustrated control circuit controls the operations, i.e., the ON state and the OFF state, of each of the thin film transistors 2b2. For example, the not-illustrated control circuit sequentially applies a control signal S1 to each of the control lines 2c1 via the flexible printed circuit board 2e1, the interconnect pad 2d1, and the control line 2c1. By the control signal S1 applied to the control line 2c1, the thin film transistor 2b2 is switched to the ON state; and an image data signal S2 from the photoelectric converters 2b can be received.

The not-illustrated amplifier/converter circuit includes, for example, multiple charge amplifiers, parallel/serial converters, and analog-digital converters.

The multiple charge amplifiers are electrically connected respectively to the data lines 2c2.

The multiple parallel/serial converters are electrically connected respectively to the multiple charge amplifiers.

The multiple analog-digital converters are electrically connected respectively to the multiple parallel/serial converters.

The not-illustrated multiple charge amplifiers sequentially receive the image data signals S2 from the photoelectric converters 2b via the data lines 2c2, the interconnect pads 2d2, and the flexible printed circuit boards 2e2.

Then, the not-illustrated multiple charge amplifiers sequentially amplify the received image data signals S2.

The not-illustrated multiple parallel/serial converters sequentially convert the amplified image data signals S2 into serial signals.

The not-illustrated multiple analog-digital converters sequentially convert, into digital signals, the image data signals S2 converted into the serial signals.

The image transmitter 4 is electrically connected to the not-illustrated amplifier/converter circuit of the signal processor 3 via an interconnect 4a. The image transmitter 4 may be formed as one body with the signal processor 3.

The image transmitter 4 configures an X-ray image based on the image data signals S2 converted into the digital signals by the not-illustrated multiple analog-digital converters. In such a case, for example, if there is a luminance difference between the central region and the peripheral edge region of an effective pixel region A, electrical processing (image correction or luminance correction) that corrects the sensitivity difference occurring due to the luminance difference can be performed when configuring the X-ray image. The data of the configured X-ray image is output from the image transmitter 4 to an external device.

The scintillator layer 5 is provided on the multiple photoelectric converters 2b (the effective pixel region A) and converts the incident X-rays into fluorescence, i.e., visible light.

The scintillator layer 5 includes a fluorescent material.

For example, the scintillator layer 5 can be formed using cesium iodide (CsI):thallium (TI), sodium iodide (NaI):thallium (TI), etc. In such a case, the scintillator layer 5 that is made of an aggregate of multiple columnar crystals is formed if the scintillator layer 5 is formed using vacuum vapor deposition, etc.

The thickness of the scintillator layer 5 can be set to be, for example, about 600 µm. For example, the diametrical of the pillar (the pillar) of the columnar crystal at the outermost surface can be set to be about 8 µm to 12 µm.

Here, in the case where the scintillator layer 5 is formed using vacuum vapor deposition, etc., a tilted portion 5a is formed in the peripheral edge portion of the scintillator layer 5 as shown in FIG. 2. The thickness of the tilted portion 5a gradually decreases toward the outer side of the scintillator layer 5. Therefore, the thickness of the tilted portion 5a is thin compared to the portion in the central region of the scintillator layer 5.

The tilted portion 5a of the scintillator layer 5 is provided on the peripheral edge region of the effective pixel region A.

The wall body 9 has a frame-like configuration and surrounds the scintillator layer 5 when viewed in plane.

When viewed in plane, the wall body 9 is provided on the outer side of the scintillator layer 5 and on the inner side of the region where the interconnect pads 2d1 and 2d2 are provided.

The material for forming the wall body 9 can have a low moisture transmittance.

The wall body 9 includes, for example, a resin (e.g., an epoxy resin, etc.) and a filler material made of an inorganic material.

For example, the filler material can be formed from talc (talc: Mg₃Si₄O₁₀(OH)₂), etc.

Talc is an inorganic material having low hardness and high slipperiness. Therefore, the wall body 9 does not become brittle even if a high concentration of talc is contained.

The concentration (the filling density) of talc can be increased if the particle size of the filler material made of talc is set to be about several µm to several tens of µm.

If the concentration of talc is increased, the moisture transmittance can be lower by a factor of about ten compared to the case of only the resin.

The viscosity of the material for forming the wall body 9 is higher than the viscosity of the material for forming the filled portion 8.

For example, the viscosity of the material for forming the wall body 9 can be set to be about 340 Pa·sec at room temperature.

Also, for example, the wall body 9 can be formed from a metal such as aluminum, etc., or an inorganic material such as glass, etc.

The filled portion 8 is provided between the tilted portion 5a of the scintillator layer 5 and the inner surface 9a of the wall body 9.

The position of the upper surface of the filled portion 8 can be about the same as the position of the upper surface of the scintillator layer 5.

In such a case, the position of the upper surface of the filled portion 8 may be the same as the position of the upper surface of the scintillator layer 5, may be slightly higher than the position of the upper surface of the scintillator layer 5, or may be slightly lower than the position of the upper surface of the scintillator layer 5.

The position of the upper surface of the filled portion 8 can be set to be slightly lower than the position of the upper surface of the wall body 9.

If the position of the upper surface of the filled portion 8 is set to be slightly lower than the position of the upper surface of the wall body 9, the material for forming the filled portion 8 can be such that the material does not flow over the upper surface of the wall body 9 when performing the filling described below.

It is favorable for the upper surface of the filled portion 8 to be flat.

If the upper surface of the filled portion 8 is flat, the sealability with the moisture-resistant body 7 bonded on the upper surface of the filled portion 8 is ensured; and high reliability can be obtained.

In such a case, the upper surface of the filled portion 8 can be caused to be flat by setting the viscosity of the material for forming the filled portion 8 to be low.

For example, it is sufficient for the viscosity of the material for forming the filled portion 8 to be about 100 Pa·sec or less at room temperature.

Also, the filled portion 8 includes a fluorescent material and converts the incident X-rays into fluorescence, i.e., visible light.

In other words, the filled portion 8 that converts the incident X-rays into fluorescence is provided above the tilted portion 5a of the scintillator layer 5.

Details relating to the effects, material, etc., of the filled portion 8 are described below.

The reflective layer 6 is provided to improve the sensitivity characteristics by increasing the utilization efficiency of the fluorescence. In other words, the light of the fluorescence that is generated by the scintillator layer 5 and the filled portion 8 and travels toward the side opposite to the side where the photoelectric converters 2b are provided is reflected by the reflective layer 6 and caused by the reflective layer 6 to travel toward the photoelectric converters 2b.

The reflective layer 6 covers the incident side of the X-rays of the scintillator layer 5 and the filled portion 8.

For example, the reflective layer 6 can be formed by coating a resin including light-scattering particles such as titanium oxide (TiO₂), etc., on the scintillator layer 5 and the filled portion 8. Also, for example, the reflective layer 6 can be formed by forming a layer made of a metal having high light reflectance such as a silver alloy, aluminum, etc., on the scintillator layer 5 and the filled portion 8.

Also, for example, the reflective layer 6 can be formed using a sheet having a surface made of a metal having high light reflectance such as a silver alloy, aluminum, etc.

The reflective layer 6 illustrated in FIG. 2 is formed by coating and curing, on the incident side of the X-rays of the scintillator layer 5 and the filled portion 8, a material made by mixing a solvent, a binder resin, and a sub-micron powder made of titanium oxide.

In such a case, the thickness of the reflective layer 6 can be set to be about 120 µm.

The reflective layer 6 is not always necessary; and it is sufficient for the reflective layer 6 to be provided as necessary.

Hereinbelow, the case is illustrated where the reflective layer 6 is provided.

The moisture-resistant body 7 is provided to suppress the degradation of the characteristics of the reflective layer 6, the characteristics of the scintillator layer 5, and the characteristics of the filled portion 8 described below due to water vapor included in the air.

Therefore, the moisture-resistant body 7 suppresses the transmission of the water vapor.

The moisture-resistant body 7 covers above the reflective layer 6. In such a case, there may be a gap between the moisture-resistant body 7 and the upper surface of the reflective layer 6; or the moisture-resistant body 7 and the upper surface of the reflective layer 6 may be in contact.

For example, if the moisture-resistant body 7 is bonded to the upper surface of the peripheral edge portion of the reflective layer 6 or the upper surface of the filled portion 8 in an environment depressurized from atmospheric pressure, the moisture-resistant body 7 and the upper surface of the reflective layer 6 are caused to be in close contact when the environment returns to atmospheric pressure.

The moisture-resistant body 7 covers above the scintillator layer 5; and the peripheral edge portion vicinity of the moisture-resistant body 7 is bonded to the reflective layer 6 above the filled portion 8.

In such a case, also, the peripheral edge portion end of the reflective layer 6 can be set to be further on the inner side of the peripheral edge portion end of the moisture-resistant body 7; and the peripheral edge portion of the moisture-resistant body 7 can be directly bonded to the filled portion 8. Or, a portion of the peripheral edge portion of the moisture-resistant body 7 can be bonded to the filled portion 8; and another portion of the peripheral edge portion of the moisture-resistant body 7 can be bonded to the reflective layer 6. Further, the peripheral edge portion of the moisture-resistant body 7 can be bonded also to the upper surface of the wall body 9.

The position of an end surface 7a of the moisture-resistant body 7 can be set so that the position is on the outer side of an effective pixel area A and on an inner side of an inner surface 9a of the wall body 9 when viewed in plane.

In such a case, when viewed in plane, the moisture resistance can be improved if the position of the end surface 7a of the moisture-resistant body 7 is set to be proximal to the inner surface 9a of the wall body 9.

The moisture resistance can be improved further by bonding the peripheral edge portion of the moisture-resistant body 7 also to the upper surface of the wall body 9. Also, as a modification, the peripheral edge portion of the moisture-resistant body 7 can be bonded only to the upper surface of the wall body 9.

The moisture-resistant body 7 has a film configuration, a foil configuration, or a thin sheet configuration.

The moisture-resistant body 7 can be formed from a material having a small moisture transmittance.

For example, the moisture-resistant body 7 can be formed from aluminum, an aluminum alloy, a low-moisture-permeability moisture-resistant film (a water vapor barrier film) in which a resin film and a film made of an inorganic material (a metal such as aluminum, an aluminum alloy, etc., a ceramic material such as SiO₂, SiON, Al₂O₃, etc.) are stacked, etc.

In such a case, if the moisture-resistant body 7 is formed using aluminum, an aluminum alloy, etc., in which the effective moisture transmittance is substantially zero, the water vapor that passes through the moisture-resistant body 7 can be substantially completely eliminated.

Also, the thickness of the moisture-resistant body 7 can be determined by considering the absorption of the X-rays, the rigidity, etc. In such a case, the absorption of the X-rays becomes too large if the thickness of the moisture-resistant body 7 is set to be too large. If the thickness of the moisture-resistant body 7 is set to be too small, the rigidity decreases and damage occurs easily.

For example, the moisture-resistant body 7 can be formed using an aluminum foil having a thickness of 0.1 mm.

The adhesive layer 10 bonds the reflective layer 6 and the peripheral edge vicinity of the moisture-resistant body 7 above the filled portion 8.

Also, the adhesive layer 10 can bond the peripheral edge portion of the moisture-resistant body 7 and the upper surface of the filled portion 8 not covered with the reflective layer 6 on the outer side of the end portion of the reflective layer 6. Further, the adhesive layer 10 also can bond the peripheral edge portion of the moisture-resistant body 7 to the upper surface of the wall body 9 in addition to the exposed portions of the filled portion 8 and the reflective layer 6. Also, the adhesive layer 10 can bond the peripheral edge portion of the moisture-resistant body 7 and only the upper surface of the wall body 9.

Thus, the moisture-resistant body 7 can be bonded by the adhesive layer 10 to at least one of the peripheral edge portion of the reflective layer 6, the upper surface of the filled portion 8 not covered with the reflective layer 6, or the upper surface of the wall body 9.

In the case where the peripheral edge portion of the reflective layer 6 is set to be on the inner side of the peripheral edge portion of the moisture-resistant body 7, the adhesive layer 10 is bonded to the upper surface of the filled portion 8; or the adhesive layer 10 is bonded to the reflective layer 6 and the upper surface of the filled portion 8. Or, the adhesive layer 10 may be bonded also to the upper surface of the wall body 9.

For example, the adhesive layer 10 can be formed by curing one of a delayed-curing adhesive, an ambient (room temperature)-curing adhesive, or a thermosetting adhesive.

The end portion of the adhesive layer 10 on the scintillator layer 5 side may be above the scintillator layer 5 or may not be above the scintillator layer 5. The case illustrated in FIG. 2 is the case where the end portion of the adhesive layer 10 on the scintillator layer 5 side is above the scintillator layer 5.

The filled portion 8 will now be described further.

As described above, the thickness of the tilted portion 5a gradually decreases toward the outer side of the scintillator layer 5. In other words, the thickness of the tilted portion 5a is thin compared to the portion in the central region of the scintillator layer 5. In the case where the thickness of the scintillator layer 5 is thin, there is a risk that a change of the light emission luminance and/or the DQE (Detective Quantum Efficiency) corresponding to the change of the thickness may occur; and the image quality in the peripheral edge region of the effective pixel region A may decrease.

That is, in the case where the tilted portion 5a is above the effective pixel region A, there is a risk that the image quality in the region of the tilted portion 5a may decrease.

In such a case, the decrease of the image quality can be suppressed if the tilted portion 5a is provided at a position distal to the effective pixel region A on the outer side. However, the downsizing of the X-ray detector 1 can no longer be realized if the tilted portion 5a is provided at the position distal to the effective pixel region A on the outer side.

Therefore, in the X-ray detector 1 according to the embodiment, the filled portion 8 that converts the incident X-rays into fluorescence is provided above the tilted portion 5a of the scintillator layer 5; and the reduced light emission luminance at the tilted portion 5a is compensated by the fluorescence generated from the filled portion 8.

Degradation of the image quality in the peripheral edge region of the effective pixel region A can be suppressed because the X-rays incident to the peripheral edge region of the effective pixel region A are converted into fluorescence by both the filled portion 8 and the tilted portion 5a of the scintillator layer 5.

The filled portion 8 includes, for example, a resin and a fluorescent material.

The fluorescent material is not particularly limited as long as the fluorescent material can convert radiation such as X-rays, etc., into fluorescence.

The fluorescent material can be, for example, cesium iodide (CsI):thallium (TI), sodium iodide (NaI):thallium (TI), gadolinium oxysulfide (Gd₂O₂S):terbium (Tb), zinc sulfide (ZnS):copper (Cu), etc.

Here, there are also cases where the light emission luminance is not equivalent between the central region of the scintillator layer 5 and the region where the filled portion 8 and the tilted portion 5a of the scintillator layer 5 are provided.

Also, a luminance intensity can differ between the inner side and the outer side of the peripheral end of the reflective layer 6 due to the reflective layer 6 covering the entire filled portion 8, covering a portion of the filled portion 8, or not covering the filled portion 8.

However, electrical processing (image correction and sensitivity correction) can be performed in the image transmitter 4 described above to correct the sensitivity difference occurring due to the luminance difference when configuring the X-ray image.

Therefore, problems of the image quality do not occur if the luminance difference between the central region and the peripheral edge region of the effective pixel region A is within a prescribed range.

Also, the scintillator layer 5 is made of an aggregate of multiple columnar crystals. Therefore, in the scintillator layer 5, the resolution characteristics improve because the spreading of the light emission is suppressed.

On the other hand, the fluorescent material of the filled portion 8 does not include columnar crystals; therefore, there is a risk that the spreading of the light emission may become large compared to the scintillator layer 5. Therefore, the resolution characteristics may degrade for the peripheral edge region of the effective pixel region A compared to the central region of the effective pixel region A.

However, generally, the important detection is performed in the central region of the effective pixel region A; and the determination of the outline of the imaging region is performed in the peripheral edge region of the effective pixel region A. In other words, it is unlikely that the important detection for which a high definition image is necessary is performed in the peripheral edge region of the effective pixel region A; and if the resolution characteristics in the peripheral edge region of the effective pixel region A degrade only slightly, there is practically no problem.

That is, there is practically no problem even in the case where a difference within a prescribed range occurs for the resolution characteristics between the central region of the scintillator layer 5 and the region where the filled portion 8 and the tilted portion 5a of the scintillator layer 5 are provided.

According to knowledge obtained by the inventors, there is practically no problem if the proportion of the fluorescent material included in the filled portion 8 is set to be 40% or more in volume fraction. In such a case, it is more desirable to set the fluorescent material included in the filled portion 8 to be 60% or more in volume fraction.

In such a case, it becomes easy to reduce the luminance difference and the characteristic difference due to X-ray energy by setting the fluorescent material included in the filled portion 8 to be the same in substance as the fluorescent material included in the scintillator layer 5.

Also, by providing the filled portion 8 including the fluorescent material, the moisture transmittance of the filled portion 8 can be reduced compared to the case where the filled portion 8 includes only the resin material. If the moisture transmittance of the filled portion 8 can be reduced, it can prevent the water vapor in the outer air from reaching the scintillator layer 5.

Therefore, the degradation of the characteristics of the scintillator layer 5 due to the water vapor from the outer air can be suppressed.

FIG. 3 is a graph for illustrating the change of the moisture permeation amount under a high-temperature high-humidity environment (60 °C-90% RH).

In FIG. 3, 200 is a case where a film made of polyparaxylylene covering the scintillator layer is provided instead of the moisture-resistant body 7 and the filled portion 8.

In FIG. 3, 100 and 110 are cases where the moisture-resistant structure with the filled portion 8 is provided.

100 is the case of the filled portion 8 including cesium iodide:thallium (CsI:Tl).

110 is the case of the filled portion 8 including gadolinium oxysulfide:terbium (Gd₂O₂S:Tb).

It can be seen from FIG. 3 that according to the moisture-resistant structure of the invention in which the filled portion 8 including the fluorescent material is provided, a drastic moisture permeation amount reduction can be realized compared to the comparative example (200 in FIG. 3).

FIG. 4 is a graph for illustrating the change of resolution characteristics under a high-temperature high-humidity environment (60 °C-90% RH).

In FIG. 4, 200 is the case where a film made of polyparaxylylene covering the scintillator layer is provided instead of the moisture-resistant body 7 and the filled portion 8.

In FIG. 4, 100 and 110 are the cases where the moisture-resistant structure with the filled portion 8 is provided.

100 is the case of the filled portion 8 including cesium iodide:thallium (CsI:Tl).

110 is the case of the filled portion 8 including gadolinium oxysulfide:terbium (Gd₂O₂S:Tb).

In these cases, it was evaluated how much the resolution characteristics obtained by the scintillator layer 5 and the reflective layer 6 degrade as the storage time elapses under the high-temperature high-humidity environment (60 °C-90% RH).

The evaluation was performed using the resolution characteristics. The resolution characteristics are more sensitive to the humidity than the light emission luminance characteristics.

The resolution characteristics were determined using a method of placing a resolution chart on the front surface side of each sample, irradiating X-rays corresponding to RQA-5 conditions, and measuring the CTF (Contrast transfer function) at 2 Lp/mm from the backside.

It can be seen from FIG. 4 that according to the moisture-resistant structure of the invention in which the filled portion 8 including the fluorescent material is provided, the degradation of the resolution characteristics can be remarkably small compared to the comparative example (200 in FIG. 4).

Also, the filled portion 8 can further include a hygroscopic material, a filler material made of an inorganic material, etc. For example, the filler material can be formed from talc, etc. For example, the hygroscopic material has a granular configuration and can be formed from calcium chloride, etc.

Thus, the degradation of the characteristics of the scintillator layer 5 due to the water vapor from the outer air can be suppressed further.

### [Second embodiment]

A method for manufacturing the X-ray detector 1 according to a second embodiment will now be illustrated.

First, the array substrate 2 is made.

For example, the array substrate 2 can be made by sequentially forming the photoelectric converters 2b, the control lines 2c1, the data lines 2c2, the interconnect pads 2d1, the interconnect pads 2d2, the protective layer 2f, etc., on the substrate 2a.

For example, the array substrate 2 can be made using a semiconductor manufacturing process.

Then, the scintillator layer 5 that includes the fluorescent material is formed using vacuum vapor deposition on the multiple photoelectric converters 2b provided on one surface side of the substrate 2a.

For example, the scintillator layer 5 can be formed by forming a film made of cesium iodide:thallium (CsI:TI) using vacuum vapor deposition. In such a case, the thickness of the scintillator layer 5 can be set to be about 600 µm.

Also, the tilted portion 5a is formed in the peripheral edge portion of the scintillator layer 5.

Then, the wall body 9 that includes a filler material and a resin and surrounds the scintillator layer 5 is formed on the one surface side of the substrate 2a.

For example, the wall body 9 can be formed by coating and curing, at the periphery of the scintillator layer 5, a resin to which a filler material is added (e.g., an epoxy resin to which a filler material made of talc is added, etc.).

For example, the coating of the resin to which the filler material is added can be performed using a dispenser apparatus, etc.

In such a case, the wall body 9 can be formed by repeating the coating and the curing of the resin to which the filler material is added one time or multiple times on the array substrate 2.

Also, the wall body 9 that has the frame-like configuration made of a metal, a resin, etc., can be bonded on the array substrate 2.

The wall body 9 also can be formed by bonding, onto the array substrate 2, a member having a sheet configuration made of a metal, a resin, etc.

In such a case, the height of the wall body 9 can be set to be slightly higher than the height of the scintillator layer 5.

Then, the filled portion 8 that includes the fluorescent material is formed between the scintillator layer 5 and the wall body 9.

At this time, the filled portion 8 is formed on the tilted portion 5a.

For example, the filled portion 8 can be formed by filling and curing a material including a fluorescent material, a resin, and a solvent between the tilted portion 5a of the scintillator layer 5 and the inner surface 9a of the wall body 9.

For example, the material for forming the filled portion 8 can be made by mixing cesium iodide:thallium (CsI:TI) which is a fluorescent material, a binder resin (e.g., an epoxy resin, a silicone resin, etc.), and a solvent.

In such a case, for example, the viscosity can be set to be about 100 Pa·sec or less at room temperature.

Also, the filled portion 8 that is flexible can be formed by further adding an epoxidized vegetable oil such as epoxidized linseed oil, etc.

If the filled portion 8 is flexible, the occurrence of peeling due to stress caused by temperature changes and by the thermal expansion difference between the members can be suppressed by the flexibility of the filled portion 8.

For example, the material for forming the filled portion 8 can be filled using a dispenser apparatus, etc.

In such a case, the filled portion 8 can be formed by repeating the filling and the curing of the material one time or multiple times.

It is favorable to perform the curing after waiting for the surface to smoothen after the filling of the material.

The position of the upper surface of the filled portion 8 may be the same as the position of the upper surface of the scintillator layer 5, may be slightly higher than the position of the upper surface of the scintillator layer 5, or may be slightly lower than the position of the upper surface of the scintillator layer 5.

Then, the reflective layer 6 is formed to cover the front surface side of the scintillator layer 5 (the incident surface side of the X-rays) and the front surface side of the filled portion 8 (the incident surface side of the X-rays). For example, the reflective layer 6 can be formed by coating and curing, on the scintillator layer 5 and the filled portion 8, a material made by mixing a sub-micron powder made of titanium oxide, a binder resin, and a solvent.

The peripheral edge of the reflective layer 6 may be caused to cover the entire filled portion 8 or may be caused to cover a portion of the filled portion 8. Also, the reflective layer 6 can be formed to cover only up to the surface of the scintillator layer 5 on the inner side of the filled portion 8.

Then, the moisture-resistant body 7 is provided to cover the front surface side (the incident surface side of the X-rays) of the reflective layer 6 and the filled portion 8.

Above the filled portion 8, the peripheral edge vicinity of the moisture-resistant body 7 is bonded to the reflective layer 6, the filled portion 8, or the wall body 9 with the adhesive layer 10 interposed.

For example, a delayed-curing adhesive, in which the curing progresses after a delay after ultraviolet irradiation, is coated onto the peripheral edge vicinity of the moisture-resistant body 7; ultraviolet rays are irradiated on the coated delayed-curing adhesive; and the portion where the delayed-curing adhesive is coated is closely adhered to the reflective layer 6 above the filled portion 8. Thus, the moisture-resistant body 7 is bonded with the adhesive layer 10 interposed.

The adhesive agent from which the adhesive layer 10 is formed may be an room temperature curing adhesive, a thermosetting adhesive, etc.

Also, the moisture-resistant body 7 can be bonded to the reflective layer 6 or the filled portion 8 in a depressurized pressure (e.g., about 10 KPa).

Then, the array substrate 2 and the signal processor 3 are electrically connected via the flexible printed circuit boards 2e1 and 2e2.

Also, the signal processor 3 and the image transmitter 4 are electrically connected via the interconnect 4a.

Also, circuit components, etc., are appropriately mounted.

Then, the array substrate 2, the signal processor 3, the image transmitter 4, etc., are housed in the interior of a not-illustrated housing.

Then, as necessary, an electrical test, an X-ray image test, a high-temperature high-humidity test, a temperature cycle test, etc., are performed to confirm the existence or absence of abnormalities of the photoelectric conversion elements 2b1 or abnormalities of the electrical connections.

Thus, the X-ray detector 1 can be manufactured.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing scope of the amended claims.

### [Reference Numeral List]

- 1: X-ray detector
- 2: array substrate
- 2a: substrate
- 2b: photoelectric converter
- 2b1: photoelectric conversion element
- 3: signal processor
- 4: image transmitter
- 5: scintillator layer
- 5a: tilted portion
- 6: reflective layer
- 7: moisture-resistant body
- 8: filled portion
- 9: wall body
- 10: adhesive layer
- A: effective pixel region

## Claims

1. A radiation detector, comprising:
an array substrate (2) including a substrate (2a) and a plurality of photoelectric conversion elements (2b), the plurality of photoelectric conversion elements (2b) being provided on one surface side of the substrate (2a);
a scintillator layer (5) including a first fluorescent material and being provided on the plurality of photoelectric conversion elements (2b);
a wall body (9) surrounding the scintillator layer (5) and being provided on the one surface side of the substrate (2a) ; and
a filled portion (8) including a second fluorescent material and being provided between the scintillator layer (5) and the wall body (9),
the scintillator layer (5) including a tilted portion (5a) in a peripheral edge portion of the scintillator layer (5), a thickness of the tilted portion (5a) gradually decreasing toward an outer side of the scintillator layer (5),
the filled portion (8) being provided on the tilted portion (5a).

2. The radiation detector according to claim 1, wherein the second fluorescent material is the same in substance as the first fluorescent material.

3. The radiation detector according to claim 1 or 2, further comprising a reflective layer (6) provided on the scintillator layer (5) and the filled portion (8), the reflective layer (6) reflecting light from the scintillator layer (5) and the filled portion (8).

4. The radiation detector according to any one of claims 1 to 3, further comprising a moisture-resistant body (7) provided on or above and covering the reflective layer (6) or the scintillator layer (5) and the filled portion (8), the moisture-resistant body (7) suppressing a transmission of water vapor.

5. A method for manufacturing a radiation detector, comprising:
forming a scintillator layer (5) on a plurality of photoelectric conversion elements (2b) by using vacuum vapor deposition, the plurality of photoelectric conversion elements (2b) being provided on one surface side of a substrate (2a), the scintillator layer (5) including a first fluorescent material;
forming a wall body (9) on the one surface side of the substrate (2a), the wall body (9) surrounding the scintillator layer (5); and
forming a filled portion (8) between the scintillator layer (5) and the wall body (9), the filled portion (8) including a second fluorescent material,
the forming of the filled portion (8) including
the filled portion (8) being formed on a tilted portion (5a), the tilted portion (5a) being formed in a peripheral edge portion of the scintillator layer(5), a thickness of the tilted portion (5a) gradually decreasing toward an outer side of the scintillator layer (5).

6. The method for manufacturing the radiation detector according to claim 5, wherein the second fluorescent material is the same in substance as the first fluorescent material.

## Patentansprüche

1. Strahlungsdetektor, umfassend:
ein Arraysubstrat (2), das ein Substrat (2a) und eine Vielzahl von photoelektrischen Umwandlungselementen (2b) enthält, wobei die Vielzahl von photoelektrischen Umwandlungselementen (2b) auf einer Oberflächenseite des Substrats (2a) vorgesehen ist;
eine Szintillatorschicht (5), die ein erstes fluoreszierendes Material beinhaltet und auf der die Vielzahl von photoelektrischen Umwandlungselementen (2b) vorgesehen ist;
einen Wandkörper (9), der die Szintillatorschicht (5) umgibt und auf der einen Oberflächenseite des Substrats (2a) vorgesehen ist; und
einen gefüllten Abschnitt (8), der ein zweites fluoreszierendes Material enthält und zwischen der Szintillatorschicht (5) und dem Wandkörper (9) vorgesehen ist,
die Szintillatorschicht (5) einen geneigten Abschnitt (5a) in einem Umfangsrandabschnitt der Szintillatorschicht (5) aufweist, wobei eine Dicke des geneigten Abschnitts (5a) allmählich zu einer Außenseite der Szintillatorschicht (5) hin abnimmt,
wobei der gefüllte Abschnitt (8) auf dem geneigten Abschnitt (5a) vorgesehen ist.

2. Strahlungsdetektor nach Anspruch 1, worin das zweite fluoreszierende Material im Wesentlichen mit dem ersten fluoreszierenden Material identisch ist.

3. Strahlungsdetektor nach Anspruch 1 oder 2, ferner umfassend eine Reflexionsschicht (6), die auf der Szintillatorschicht (5) und dem gefüllten Abschnitt (8) vorgesehen ist, wobei die Reflexionsschicht (6) Licht von der Szintillatorschicht (5) und dem gefüllten Abschnitt (8) reflektiert.

4. Strahlungsdetektor nach einem der Ansprüche 1 bis 3, ferner umfassend einen feuchtigkeitsbeständigen Körper (7), der auf oder über der Reflexionsschicht (6) oder der Szintillatorschicht (5) und dem gefüllten Abschnitt (8) vorgesehen ist und diese bedeckt, wobei der feuchtigkeitsbeständige Körper (7) eine Übertragung von Wasserdampf unterdrückt.

5. Verfahren zur Herstellung eines Strahlungsdetektors, umfassend:
Bilden einer Szintillatorschicht (5) auf einer Vielzahl von photoelektrischen Umwandlungselementen (2b) unter Verwendung der Vakuumdampfabscheidung, wobei die Vielzahl von photoelektrischen Umwandlungselementen (2b) auf einer Oberflächenseite eines Substrats (2a) vorgesehen ist, wobei die Szintillatorschicht (5) ein erstes fluoreszierendes Material enthält;
Bilden eines Wandkörpers (9) auf der einen Oberflächenseite des Substrats (2a), wobei der Wandkörper (9) die Szintillatorschicht (5) umgibt; und
Bilden eines gefüllten Abschnitts (8) zwischen der Szintillatorschicht (5) und dem Wandkörper (9), wobei der gefüllte Abschnitt (8) ein zweites fluoreszierendes Material enthält,
wobei das Bilden des gefüllten Abschnitts (8) Folgendes enthält
Ausbilden des gefüllten Abschnitts (8) auf einem geneigten Abschnitt (5a), wobei der geneigte Abschnitt (5a) in einem Umfangsrandabschnitt der Szintillatorschicht (5) ausgebildet ist, wobei eine Dicke des geneigten Abschnitts (5a) allmählich zu einer Außenseite der Szintillatorschicht (5) hin abnimmt.

6. Verfahren zur Herstellung des Strahlungsdetektors nach Anspruch 5, bei dem das zweite fluoreszierende Material im Wesentlichen mit dem ersten fluoreszierenden Material identisch ist.

## Revendications

1. Détecteur de rayonnement, comprenant :
un substrat de matrice (2) incluant un substrat (2a) et une pluralité d'éléments de conversion photoélectrique (2b), la pluralité d'éléments de conversion (2b) étant fournie sur un côté de surface du substrat (2a) ;
une couche de scintillateur (5) incluant un premier matériau fluorescent et étant fournie sur la pluralité d'éléments de conversion (2b) ;
un corps de paroi (9) entourant la couche de scintillateur (5) et étant fourni sur le un côté de surface du substrat (2a) ; et
une portion chargée (8) incluant un second matériau fluorescent et étant fournie entre la couche de scintillateur (5) et le corps de paroi (9),
la couche de scintillateur (5) incluant une portion inclinée (5a) dans une portion de bord périphérique de la couche de scintillateur (5), une épaisseur de la portion inclinée (5a) diminuant progressivement vers un côté externe de la couche de scintillateur (5),
la portion chargée (8) étant fournie sur la portion inclinée (5a).

2. Détecteur de rayonnement selon la revendication 1, dans lequel le second matériau fluorescent est identique en substance au premier matériau fluorescent.

3. Détecteur de rayonnement selon la revendication 1 ou 2, comprenant de plus une couche réfléchissante (6) fournie sur la couche de scintillateur (5) et la portion chargée (8), la couche réfléchissante (6) réfléchissant de la lumière de la couche de scintillateur (5) et la portion chargée (8).

4. Détecteur de rayonnement selon l'une quelconque des revendications 1 à 3, comprenant de plus un corps résistant à l'humidité (7) fourni sur ou au-dessus et couvrant la couche réfléchissante (6) ou la couche de scintillateur (5) et la portion chargée (8), le corps résistant à l'humidité (7) supprimant une transmission de vapeur d'eau.

5. Procédé de fabrication d'un détecteur de rayonnement, comprenant :
la formation d'une couche de scintillateur (5) sur une pluralité d'éléments de conversion (2b) en utilisant un dépôt en phase vapeur sous vide, la pluralité d'éléments de conversion (2b) étant fournie sur un côté de surface d'un substrat (2a), la couche de scintillateur (5) incluant un premier matériau fluorescent ;
la formation d'un corps de paroi (9) sur le un côté de surface du substrat (2a), le corps de paroi (9) entourant la couche de scintillateur (5) ; et
la formation d'une portion chargée (8) entre la couche de scintillateur (5) et le corps de paroi (9), la portion chargée (8) incluant un second matériau fluorescent,
la formation de la portion chargée (8) incluant
la portion chargée (8) étant formée sur une portion inclinée (5a), la portion inclinée (5a) étant formée dans une portion de bord périphérique de la couche de scintillateur (5), une épaisseur de la portion inclinée (5a) diminuant progressivement vers un côté externe de la couche de scintillateur (5).

6. Procédé de fabrication du détecteur de rayonnement selon la revendication 5, dans lequel le second matériau fluorescent est identique en substance au premier matériau fluorescent.
